# EUROPEAN PATENT SPECIFICATION

(11) **EP 1 804 296 B1**
(45) Date of publication and mention of the grant of the patent: **01.10.2008**
(21) Application number: 05790435.1
(22) Date of filing: 05.10.2005
(51) Int. Cl.: H01L 27/14, H01L 23/02, H01L 23/10

(54) **LIGHT-RECEIVING DEVICE**
LICHTEMPFANGSEINRICHTUNG
DISPOSITIF RECEPTEUR DE LUMIERE

(30) Priority: 13.10.2004 JP 2004298670; 31.08.2005 JP 2005252886
(43) Date of publication of application: 04.07.2007
(73) Proprietor: SUMITOMO BAKELITE CO., LTD., Tokyo 140-0002 (JP)
(72) Inventor: KUSUNOKI, Junya, agawa 2-chome, Shinagawa-ku, Tokyo 14000 (JP); HIRANO, Takashi, agawa 2-chome, Shinagawa-ku, Tokyo 14000 (JP)
(74) Representative: Schnappauf, Georg
(86) International application number: PCT/JP2005/018466
(87) International publication number: WO 2006/040986

(56) References cited:
- JP-A- 2002 329 852
- JP-A- 2003 147 321
- JP-A- 2004 277 726
- US-A1- 2003 020 076
- US-A1- 2003 051 751

## Description

### TECHNICAL FIELD

The present invention relates to a substrate provided with a light receiving element, a sealing member and a light-receiving device comprising a transparent cover.

### BACKGROUND ART

Since a light receiving element is required to precisely capture incident light in a light-receiving device, it is needed to isolate thereof from an external atmospheric air such as moisture air and the like. Here, a transparent cover of a glass plate or the like is generally provided above the light receiving element, and the light receiving element is isolated from the external atmospheric air by a manner described below.

Typically known methods for protecting the light receiving element from the exterior include a method for shielding against an external moisture by filling the light receiving element region with a resin and in addition include a method for shielding against an external moisture by surrounding a circumference of a light receiving element region with a resin while a region above the light receiving element region is remained as in a hollow structure without filling thereof with a resin (Patent Literature 1 and 2). Here, an epoxy resin is employed for the above-described resin.

### [Patent Literature 1]

Japanese Laid-Open Patent Publication No. 2004-31,939

### [Patent Literature 2]

Japanese Laid-Open Patent Publication No. 2002-329,852

Document US 2003/020076 A discloses a light-receiving device with a sealing member made of resin. Document US 2003/0051751 A discloses the use of norbornadiene as a sealant for solar cells. Document JP-A- 2004 277726 discloses various olefin resins.

### DISCLOSURE OF THE INVENTION

Nonetheless, in the light receiving element having the structure that isolates the light receiving element from the exterior by employing an epoxy resin, moisture may seep in the light receiving element portion such that the epoxy resin may absorb moisture. This may cause a haze in a surface of the light receiving element, leading to a time degradation in a light-receiving ratio.
The present invention has been conceived in view of the foregoing situation, and an object of the present invention is to provide a light-receiving device that is hard to absorb water from the exterior and exhibits less time degradation in the light-receiving ratio.

According to the present invention, there is provided a light-receiving device, as recited in claim 1. Further advantageous embodiments are recited in the dependent claims.

Since the light receiving element of the present invention employs the sealing member containing a cyclic olefin resin, which exhibits lower hygroscopicity, water seeping in the light receiving element portion can be effectively inhibited. This can provide a light-receiving device with a reduced time degradation in a light-receiving ratio.

### BRIEF DESCRIPTION OF THE DRAWINGS

The above and other objects, advantages and features of the present invention will be more apparent from the following description taken in conjunction with the accompanying drawings as described below.

Fig. 1 is a cross-sectional view of a light-receiving device, in which a gap between a light receiving element and a transparent cover member is with a sealing member.
Fig. 2 is a cross-sectional view of a light-receiving device having a hollow structure that employs no adhesive agent.
Fig. 3 is a cross-sectional view of a light-receiving device having a hollow structure that employs an adhesive agent.
Fig. 4 is a cross-sectional view of a light-receiving device of a wafer level chip size package (CSP) structure having a hollow structure that employs an adhesive agent.

### BEST MODE FOR CARRYING OUT THE INVENTION

A light-receiving device of the present invention will be described as follows in reference to exemplary implementations by applying thereof to complementary metal-oxide semiconductor (CMOS) image sensors having different types of configurations. In addition to above, the light-receiving device of the present invention is not limited thereto, and may include various embodiments such as charge-coupled device (CCD) and the like, in addition to a CMOS image sensor. A CMOS image sensor is formed on a support, and includes a light receiving element. A support 1 is a silicon wafer including a plurality of integrated circuits that constitute other image sensors.

### (FIRST EMBODIMENT)

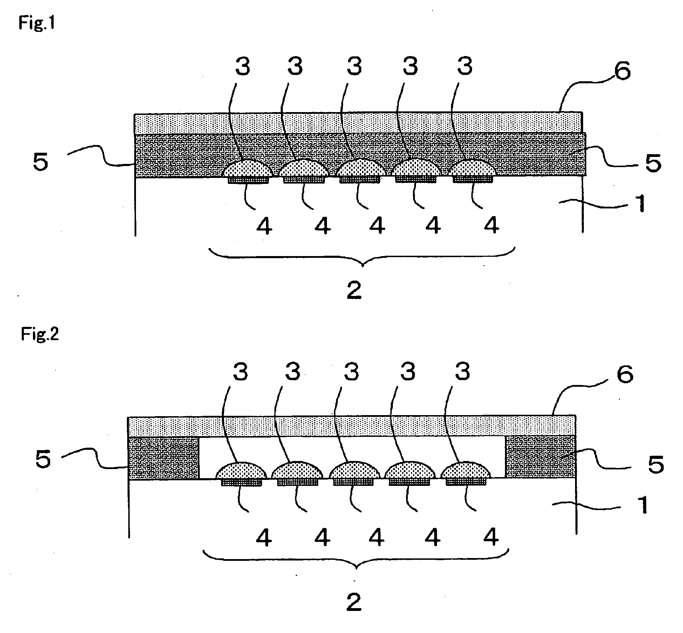

Fig. 1 is a diagram, showing a schematic structure of a light receiving element according to the present embodiment. Such light receiving element includes a substrate 1, a light receiving element 2 provided on a surface of the substrate 1, a transparent cover 6 provided above such surface, and a sealing member 5, which is provided to fill a gap between the substrate 1 and the transparent cover 6 and adopted for providing a seal for the light receiving element 2 from the exterior thereof. The sealing member 5 is composed of a material containing a norbornene resin.
The light receiving element 2 on the support 1 is presented by a two-dimensional array of pixel sensors composed of photoelectric regions 4 and microlenses 3, and this may alternatively have a standard configuration. An image resolution that the image sensor can be achieved is determined by the sizes and number of the pixel sensors, and the arrangement thereof ordinarily includes several hundreds to several thousands of pixel sensors per one column or one row.

An arrangement of microlenses 3 is formed on the photoelectric region 4. The microlenses 3 are arranged corresponding to individual photoelectric regions 4, respectively. Concerning these microlenses 3, cylindrical optical lenses can be formed by, for example, comparting a layer composed of a transparent resin (including a photo resist) having a refractive index of 1.3 to 2.0 into predetermined geometries via a photolithographic processes or the like, and then melting the transparent resin of the respective compartments via a thermal processing, rounding a corner thereof by utilizing a surface tension and then cooling thereof. These microlenses 3 ordinarily have widths of about 2 to 6 µm, and heights of about 1 to 2 µm. These light receiving elements are wrapped up by the sealing member 5 so as to be in contact with and embedded by the sealing member 5. A transparent cover 6 is provided on the sealing member 5. A light passes through the sealing member 5 from above of such transparent cover 6 to reach to the light receiving element.
The sealing member 5 contains a norbornene in resin, so that advantageous effects such as less absorbability of external moisture, less deterioration in the light-receiving ratio, better manufacturing stability and the like, can be obtained. The norbornene resin may be present uniformly over entire of the sealing member 5, or may be present locally in portions of the sealing member 5. It is preferable that the norbornene in resin is employed as a major constituent of the sealing member 5.

Next, a method for manufacturing the above-described light-receiving device will be described. On a semiconductor substrate including the light receiving element having microlenses 3 disposed corresponding to each of the photo acceptance regions formed thereon and surface electrodes formed in regions except the regions having microlenses, a norbornene resin having epoxy group and a resin composition containing a crosslinker are applied by employing a spin coater and are dried to obtain a coating film. Further, a transparent cover is disposed on such coating film, and then the entire thereof is heated to a temperature of 50 degree C to 250 degree C to join thereof. As such, the light-receiving device as shown in Fig. 1 is obtained.

In an example not part of this invention, an epoxy resin is often conventionally employed for the above-described sealing member 5 in place of a cyclic olefin resin having epoxy group, and smaller difference in a refractive index between the light receiving element and the epoxy resin may causes a problem of losing focusing function, when the light receiving element is protected so as to be directly embedded in contact with the epoxy resin. Further, a problem of reducing a light-receiving ratio of the light receiving element may be occurred due to a deterioration of the epoxy resin on the light receiving element caused by a light for a long-term use.
In the present invention, a norbornene resin having epoxy group is employed for the sealing member, so that the above-described deterioration of the resin can be considerably inhibited, and a suitable difference in the refractive index between the light receiving element and the epoxy resin can be ensured, leading to achieving a continuous sustainment of the focusing ability.

### (SECOND EMBODIMENT)

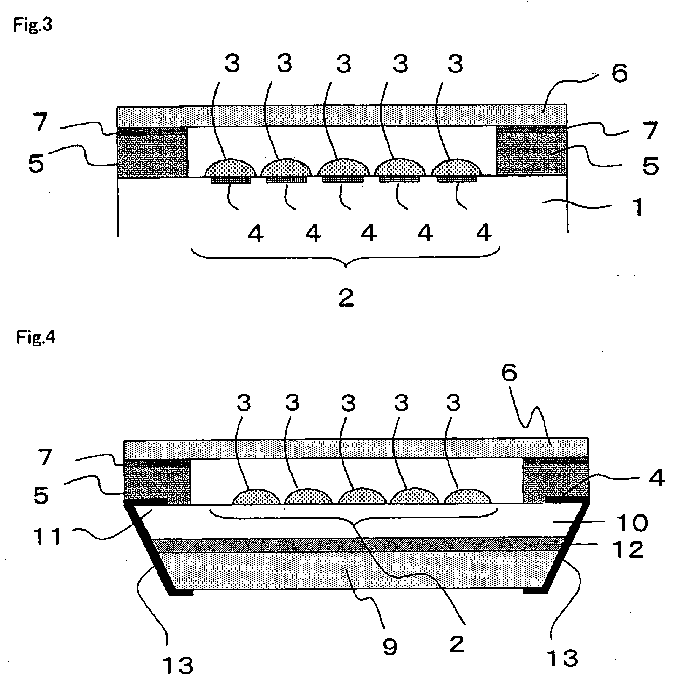

Fig. 2 is a diagram, showing a schematic structure of a light receiving element according to the present embodiment. Such light receiving element includes a substrate 1, a light receiving element 2 provided on a surface of the substrate 1 and a transparent cover 6 provided above the surface thereof. A sealing member 5 composed of a material containing a norbornene resin is provided between the substrate 1 and the transparent cover 6. The sealing member 5 is provided to surround the light receiving element 2 in a position remote from the light receiving element 2, and joins the substrate 1 with the transparent cover 6 and has a hollow portion formed in the inner side thereof. The sealing member 5 is composed of a material containing a norbornene resin.
The sealing member 5 functions as a spacer (dam) for forming a hollow structure between the transparent cover 6 and the light receiving element 2. The sealing member 5 may be joined to the transparent cover 6 through the adhesive agent 7 as shown in Fig. 3. The sealing member 5 is composed of a norbornene resin having epoxy group, and more preferably composed of a photosensitive norbornene resin having epoxy group. An addition of a photosensitivity provides benefits such as an improved workability, higher location accuracy and higher uniformity in the dimensional height. Further, the sealing member 5 containing the norbornene olefin resin having epoxy group is hard to absorb an external moisture, so that advantageous effects such as preventing a loss of transparency in the transparent cover 6 can be obtained.

Next, a method for manufacturing the above-described light-receiving device will be described. A photosensitive norbornene resin composition having epoxy group is applied on the semiconductor substrate provided with the microlenses 3 by employing a spin coater, and then, is heated and dried with a hot plate to obtain a coating film. An exposure to light is conducted over portions for forming a dam in the coating film, and then, is heated to a temperature of 50 degree C to 180 degree C for several minutes with a hot plate for accelerating a cross linking reaction. Next, dipping in developer is conducted for about 30 seconds to dissolve to unexposed portions to remove thereof.
Further, a transparent cover is disposed on such coating film, and then the whole thereof is heated to a temperature of 50 degree C to 250 degree C to join thereof. Alternatively, after heating the coating film to a temperature of 50 degree C to 250 degree C, an adhesive agent is applied on such coating film, and a transparent cover is disposed thereon, and joins thereof. As a result, a dam is formed so as to surround the light receiving element region, and thus the light-receiving device of residue-free on the microlenses 3 is manufactured.

### (THIRD EMBODIMENT)

Fig. 3 and Fig. 4 are diagrams, showing a schematic structure of a light receiving element according to the present embodiment. Fig. 4 shows a cross-sectional view of a CMOS image sensor, which has a wafer level chip size package (CSP) structure that is a type of a light-receiving device shown in Fig. 3 and has a hollow structure of the present invention.

In the light-receiving device according to the present embodiment, the sealing member 5 is disposed so as to surround the light receiving element 2 to join the substrate 1 with the transparent cover 6, and has a hollow portion formed in the inner side thereof. An upper portion of the sealing member 5 has a flat geometry, and a transparent cover is provided on the surface thereof through an adhesive agent 7, as required. The sealing member 5 is higher than the microlenses 3, and if the transparent cover 6 is provided on the upper surface of the sealing member 5, an air gap is formed between the microlenses 3 and the transparent cover 6. Such sealing member 5 has a height of about 5 to 40 µm and a width of 100 to 1,000 µm. Nonetheless, a considerably different geometry of the sealing member 5 may alternatively be employed according to various types of factors such as a size of a pixel sensor, a height of a microlens 3 and the like.

After forming the sealing member 5, a transparent cover 6 is bonded thereto by a heat. On this occasion, an adhesive agent 7 may be employed as required. A thermosetting adhesive agent 7 is applied on the upper surface of the sealing member 5. The adhesive agent 7 is selectively applied on the sealing member 5 via a screen printing process and the like, a transparent cover 6 is disposed on the sealing member 5, and then the adhesive agent 7 is cured via a thermal processing. In the configuration of the present invention, the sealing member 5 having a predetermined height is provided to bond a wafer 10 serving as a support 1 and the transparent cover 6, so that a constant distance between the wafer 10 and the transparent cover 6 can be provided, leading to facilitating an alignment thereof. Such bonding process is preferably conducted in a vacuum or in an inert gas atmosphere such as nitrogen and the like.

After the transparent cover 6 is bonded to the upper surface of the sealing member 5, an interconnect is formed by employing, for example, a method for forming an electric lead that is employed in a shell case-type CSP, and the formed interconnect is diced into individual light receiving elements, and then separated into individual light-receiving devices, thereby obtaining the light-receiving device composed of the CSP as shown in Fig. 4.
The light-receiving device shown in Fig. 4 employs a glass substrate for the transparent cover 6. In such CSP, leads 13 joined to the electrode pads 11 extend to the back surface of the chip to achieve forming interconnects in the back surface thereof, such that a space for the interconnects can be considerably reduced, as compared with a package for joining the semiconductor chip via a wire bonding. Further, since employing such method achieves conducting the whole manufacturing process from forming the semiconductor device to packaging thereof under a wafer condition, leading to a considerably reduced manufacturing cost as compared with the conventional light-receiving devices.

In addition, since a division into the respective elements is conducted after the transparent cover is bonded thereto in the manufacture of the light-receiving device, no stain is caused in the surface of the light receiving element during the dicing process, thereby ensuring a reliability.

The embodiments of the present invention have been described as mentioned above. Descriptions on the norbornene resin employed for the sealing member of the present invention will be made as follows. Other types of resins, not part of this invention, will also be described as illustrative examples.

Cyclic olefin monomers available generally include: monocyclic compounds such as cyclohexene, cyclooctene and the like; and polycyclic compounds such as norbornene, norbornadiene, dicyclopentadiene, dihydrodicyclopentadiene, tetracyclododecen, tricyclopentadiene, dihydrotricyclopentadiene, tetracyclopentadiene, dihydrotetracyclopentadiene and the like. Substitution products having functional group bound to these monomers may alternatively be employed.

Cyclic olefin resin available typically includes a polymer of the above-described cyclic olefin monomers. In addition to above, an available polymerization process includes a known process such as random polymerization, block polymerization and the like. Typical example may include (co)-polymer of norbornene type monomer, copolymer of norbornene type monomer and other types of monomers available for copolymerizing with α-olefins or the like, and hydrogenated products of these copolymers. These cyclic olefin resins may be manufactured by a known polymerization process, and such polymerization process typically includes an addition polymerization process and a ring-opening polymerization process. When a norbornene resin is employed for the sealing member, benefits of providing an improved manufacturing stability such as achieving a higher precision of the patterning in the manufacture of the light-receiving device can be obtained.

Typical addition polymer of cyclic olefin resin may include: (1) addition (co)-polymer of norbornene type monomer obtained by addition (co)-polymerizing norbornene type monomer; (2) addition copolymer of norbornene type monomer and ethylene or α-olefins; and (3) addition copolymer of norbornene type monomer and nonconjugated diene, and in addition with other type of monomer as required. These resins may be obtained with any of known polymerization processes.

Typical ring-opened polymer of cyclic olefin resin may includes: (4) ring-opened (co)-polymer of norbornene type monomer, and in addition a resin of hydrogenated product of such (co)-polymer as required;(5) a ring-opened copolymer of norbornene type monomer and ethylene or α-olefins, and in addition a resin of hydrogenated product of such (co)-polymer as required; and (6) a ring-opened copolymer of norbornene type monomer and nonconjugated diene or other monomer and in addition a resin of hydrogenated product of such (co)-polymer as required. These resins may be obtained with any of known polymerization processes.

A cyclic olefin resin preferably has reactive functional groups. Specific examples of such reactive functional groups includes epoxy group such as glycidyl ether group and the like, oxetane group, carboxyl group, hydroxyl group, unsaturated bonds, amino group or the like. Epoxy group is particularly preferable among these groups.

While the cyclic olefin resin having epoxy group can generally be obtained by directly polymerizing monomer containing epoxy group in its molecular, similar polymer may also be obtained via a manner for introducing epoxy group in side-chain via a conversion reaction after the polymerization. Typical conversion reaction includes known manners such as: inducing a grafting reaction of the above-described polymer with unsaturated monomer containing epoxy group; inducing a reaction of reactive functional group site in the above-described polymer with compounds having epoxy group; inducing a direct epoxidation of the above-described polymer having carbon-carbon double bond in molecular by employing epoxidation agents such as peroxy acid, hydroperoxide, and the like.

The addition polymer of a cyclic olefin resin is obtained by a coordination polymerization by utilizing a metal catalyst, or a radical polymerization. In the coordination polymerization among these, the polymer is obtained by polymerizing monomer in solution in the presence of a transition metal catalyst (NiCOLE R. GROVE et al., Journal of Polymer Science: part B, Polymer Physics, Vol. 37, pp. 3003-3010 (1999)).

Nickel and the platinum catalysts typically employed metal catalysts in the coordination polymerization are described in PCT WO97/33,198 and PCT WO00/20,472. Typical metal catalyst for the coordination polymerization includes known metal catalysts such as: (toluene) bis (perfluoro phenyl) nickel; (mesilene) bis (perfluorophenyl) nickel; (benzene) bis (perfluorophenyl) nickel; bis (tetrahydro) bis (perfluorophenyl) nickel; bis (ethyl acetate) bis (perfluorophenyl) nickel; bis (dioxane) bis (perfluorophenyl) nickel and the like.

Typical radical polymerization technology is described in Encyclopedia of Polymer Science, John Wiley & Sons, 13, 708(1988).
Radical polymerization is generally induced by reacting monomer in solution with elevating a temperature to 50 degree C to 150 degree C in the presence of a radical initiator. Typical radical initiator includes: azobis (isobutyronitrile) (AIBN); benzoyl peroxide; lauryl peroxide; azobis (iso captronitrile); azobis (isoleronitrile); t-butyl hydroperoxide or the like.

The ring-opened polymer of a cyclic olefin resin is obtained by: ring-opening (co)-polymerizing at least one or more norbornene type monomer with a catalyst of titanium or tungsten compound via a known ring opening (co)-polymerization process to manufacture a ring-opening (co)-polymer; and then hydrogenating carbon-carbon double bond in the aforementioned ring-opening (co)-polymer via an ordinary hydrogenation process as required to manufacture a thermoplastic saturated norbornene resin.

Suitable polymerization solvent of the above-described polymerization system includes hydrocarbons or aromatic solvents. Typical hydrocarbon solvent includes pentane, hexane, heptane, cyclohexane or the like, although it is not limited thereto. Typical aromatic solvent includes benzene, toluene, xylene, mesitylene or the like, although it is not limited thereto. Diethyl ether, tetrahydrofuran, ethyl acetate, esters, lactones, ketones, amides may also be employed. These solvents, alone or a combination thereof, may be employed as a polymerization solvent.

Molecular weight of the cyclic olefin resin may be controlled by adjusting a ratio of an initiator and a monomer, or by adjusting a polymerization time. When the coordination polymerization described above is employed, as disclosed in US Patent No. 6,136,499, molecular weight can be controlled by employing a chain transfer catalyst. In the present invention and examples, α-olefin such as ethylene, propylene, 1-hexane, 1-decene, 4-methyl -1-pentene and the like is suitable for controlling molecular weight.

In the present invention and examples, weight-average molecular weight is 10,000-500,000, preferably 80,000-200,000, and more preferably 100,000-125,000. Weight-average molecular weight may be measured via a gel permeation chromatography (GPC) employing normal polynorbornene (implemented in relation to ASTM DS 3536-91).

Specific examples of alkyl group include methyl, ethyl, propyl, isopropyl, butyl, pentyl, hexyl, heptyl, octyl, nonyl, decyl, dodecyl, cyclopentyl, cyclohexyl, cyclo octyl, or the like, specific examples of alkenyl group include vinyl, allyl, butynyl, cyclohexyl or the like, specific example of alkynyl group include ethynyl, 1-propynyl, 2-propynyl, 1-butynyl, 2-butynyl or the like, specific examples of aryl group include phenyl, naphthyl, anthracenyl or the like, and specific group examples of aralkyl group include benzyl, phenethyl or the like, although it is not limited thereto.

Concerning functional group having ester group, functional group having ketone group and functional group having ether group, structures thereof is not particularly limited, if functional group has the above-described group. While functional group having glycidyl ether group is presented as a preferable specific example of functional group containing epoxy group, structures thereof is not particularly limited, if functional group has epoxy group.

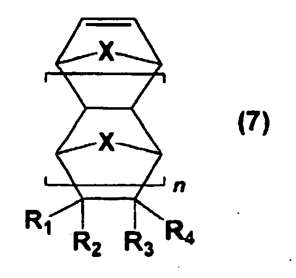

[In formula (7), X is any of O, CH₂ and (CH₂)₂, and n is an integer number of 0 to 5. R₁ to R₄ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₄ may be the same or different. In formula (7), in R₁ to R₄ of the whole repeated units, at least one or more thereof is functional group having epoxy group.]

Typical cyclic olefin monomer employed for manufacturing a cyclic olefin resin includes, for example: monomer having alkyl group, such as 5-methyl -2-norbornene, 5-ethyl -2-norbornene, 5-propyl -2-norbornene, 5-butyl -2-norbornene, 5-pentyl -2-norbornene, 5-hexyl -2-norbornene, 5-heptyl -2-norbornene, 5-octyl -2-norbornene, 5-nonyl -2-norbornene, 5-decyl -2-norbornene and the like, monomer having alkenyl group such as 5-allyl -2-norbornene, 5-methylidene -2-norbornene, 5-ethylidene -2-norbornene, 5-isopropylidene -2-norbornene, 5-(2-propenyl) -2-norbornene, 5-(3-butenyl) -2-norbornene, 5-(1-methyl -2-propenyl) -2-norbornene, 5-(4-pentenyl) -2-norbornene, 5-(1-methyl -3-butenyl) -2-norbornene, 5-(5-hexenyl) -2-norbornene, 5-(1-methyl -4-pentenyl) -2-norbornene, 5-(2,3- dimethyl -3-butenyl) -2-norbornene, 5-(2-ethyl -3-butenyl) -2-norbornene, 5-(3,4-dimethyl -4-pentenyl) -2-norbornene, 5 -(7-octenyl) -2-norbornene, 5-(2-methyl -6-heptenyl) -2-norbornene, 5-(1,2- dimethyl -5-hexenyl) -2-norbornene, 5-(5-ethyl -5-hexenyl) -2-norbornene, 5-(1,2,3-trimethyl -4-pentenyl) -2-norbornene and the like, monomer having alkynyl group such as 5-ethynyl -2-norbornene and the like, monomer having alkoxy silyl group such as dimethylbis ((5-norbornene -2-yl) methoxy)) silane and the like, monomer having silyl group such as 1,1,3,3,5,5- hexamethyl-1,5-dimethylbis ((2-(5-norbornene -2-yl) ethyl) trisiloxane) and the like, monomer having aryl group such as 5-phenyl -2-norbornene, 5-naphthyl -2-norbornene, 5-pentafluorophenyl -2-norbornene and the like, monomer having aralkyl group such as 5-benzil -2-norbornene, 5-phenethyl -2-norbornene, 5-pentafluorophenyl methane -2-norbornene, 5-(2-pentafluorophenyl ethyl) -2-norbornene, 5-(3-pentafluorophenyl propyl) -2-norbornene and the like, monomer having alkoxy silyl group such as dimethylbis ((5-norbornene -2-yl) methoxy)) silane, 5-trimethoxysilyl -2-norbornene, 5-tri ethoxy silyl -2-norbornene, 5-(2-trimethoxysilyl ethyl) -2-norbornene, 5-(2-triethoxy silyl ethyl) -2-norbornene, 5-(3-trimethoxysilylpropyl) -2-norbornene, 5-(4-trimethoxybutyl) -2-norbornene, 5-trimethyl silylmethyl ether -2-norbornene and the like, monomer having hydroxyl group, ether group, carboxyl group, ester group, acryloyl group or methacryloyl group such as 5-norbornene -2-methanol and alkylether thereof, acetic acid 5-norbornene -2-methyl ester, propionic acid 5-norbornene -2-methyl ester, butanoic acid 5-norbornene -2-methyl ester, valeric acid 5-norbornene -2-methyl ester, caproic acid 5-norbornene -2-methyl ester, caprylic acid 5-norbornene -2-methyl ester, capric acid 5-norbornene -2-methyl ester, lauric acid 5-norbornene -2-methyl ester, stearic acid 5-norbornene -2-methyl ester, oleic acid 5-norbornene -2-methyl ester, linolenic acid 5-norbornene -2-methyl ester, 5-norbornene -2-carboxylate, 5-norbornene -2-carboxylic acid methyl ester, 5-norbornene -2-carboxylic acid ethyl ester, 5-norbornene -2-carboxylic acid t-butyl ester, 5-norbornene -2-carboxylic acid i-butyl ester, 5-norbornene -2-carboxylic acid trimethylsilyl ester, 5-norbornene -2-carboxylic acid triethylsilyl ester, 5-norbornene -2-carboxylic acid isobonyl ester, 5-norbornene -2-carboxylic acid 2-hydroxyethyl ester, 5-norbornene -2-methyl -2-carboxylic acid methyl ester, cinnamic acid 5-norbornene -2-methyl ester, 5-norbornene -2-methylethyl carbonate, 5-norbornene -2-methyl n-butyl carbonate, 5-norbornene -2-methyl t-butyl carbonate, 5-methoxy -2-norbornene, (meta) acrylic acid 5-norbornene -2-methyl ester, (meta) acrylic acid 5-norbornene -2-ethyl ester, (meta) acrylic acid 5-norbornene -2-n-butyl ester, (meta) acrylic acid 5-norbornene -2-n-propyl ester, (meta) acrylic acid 5-norbornene -2-iso butyl ester, (meta) acrylic acid 5-norbornene -2-iso propyl ester, (meta) acrylic acid 5-norbornene -2-hexyl ester, (meta) acrylic acid 5-norbornene -2-octyl ester, (meta) acrylic acid 5-norbornene -2-decyl ester and the like, monomer having epoxy group such as 5-[(2,3-epoxypropoxy) methyl] -2-norbornene] and the like, or, monomer composed of tetracyclic ring such as 8-methoxycarbonyl tetracyclo [4.4.0.1^{2,5}.1^{7,10}] dodec -3-ene, 8-ethoxycarbonyl tetracyclo [4.4.0.1^{2,5}.1^{7,10}] dodec -3-ene, 8-n- propylcarbonyl tetracyclo [4.4.0.1^{2,5}.1^{7,10}] dodec -3-ene, 8-i- propylcarbonyl tetracyclo [4.4.0.1^{2,5}.1^{7,10}] dodec -3-ene, 8-n- butoxycarbonyl tetracyclo [4.4.0.1^{2,5}.1^{7,10}] dodec -3-ene, 8-(2-methylpropoxy) carbonyl tetracyclo [4.4.0.1^{2,5}.1^{7,10}] dodec -3-ene, 8-(1-methyl propoxy) carbonyl tetracyclo [4.4.0.1^{2,5}.1^{7,10}] dodec -3-ene, 8-t-butoxycarbonyl tetracyclo [4.4.0.1^{2,5}.1^{7,10}] dodec -3-ene, 8-cyclohexyl oxycarbonyl tetracyclo [4.4.0.1^{2,5}.1^{7,10}] dodec -3-ene, 8-(4 '- t- butylcyclohexyloxy) carbonyl tetracyclo [4.4.0.1^{2,5}.1^{7,10}] dodec -3-ene, 8-phenoxycarbonyl tetracyclo [4.4.0.1^{2,5}.1^{7,10}] dodec -3-ene, 8-tetrahydrofuranyloxy carbonyl tetracyclo [4.4.0.1^{2,5}.1^{7,10}]-3- dodecen, 8-tetrahydropyranyloxy carbonyl tetracyclo [4.4.0.1^{2,5}.1^{7,10}] dodec -3-ene, 8-methyl -8-methoxycarbonyl tetracyclo [4.4.0.1^{2,5}.1^{7,10}] dodec -3-ene, 8-methyl -8-ethoxycarbonyl tetracyclo [4.4.0.1^{2,5}.1^{7,10}] dodec -3-ene, 8-methyl -8-n- propoxycarbonyl tetracyclo [4.4.0.1^{2,5}.1^{7,10}] dodec -3-ene, 8-methyl -8-iso propoxycarbonyl tetracyclo [4.4.0.1^{2,5}.1^{7,10}] dodec -3-ene, 8-methyl -8-n- butoxycarbonyl tetracyclo [4.4.0.1^{2,5}.1^{7,10}] dodec -3-ene, 8-methyl -8-(2-methyl propoxy) carbonyl tetracyclo [4.4.0.1^{2,5}.1^{7,10}] dodec -3-ene, 8-methyl -8- (1-methyl propoxy) carbonyl tetracyclo [4.4.0.1^{2,5}.1^{7,10}] dodec -3-ene, 8-methyl -8-t- butoxycarbonyl tetracyclo [4.4.0.1^{2,5}.1^{7,10}] dodec-3-ene, 8-methyl -8-cyclohexyloxycarbonyl tetracyclo [4.4.0.1^{2,5}.1^{7,10}] dodec -3-ene, 8-methyl -8-(4 '- t-butylcyclohexyloxy) carbonyl tetracyclo [4.4.0.1^{2,5}.1^{7,10}] dodec -3-ene, 8-methyl -8-phenoxycarbonyl tetracyclo [4.4.0.1^{2,5}.1^{7,10}] dodec -3-ene, 8-methyl -8-tetrahydrofuranyloxycarbonyl tetracyclo [4.4.0.1^{2,5}.1^{7,10}] dodec -3-ene, 8-methyl -8-tetrahydropyranyloxycarbonyl tetracyclo [4.4.0.1^{2,5}.1^{7,10}]-3-dodecen, 8-methyl -8-acetoxy tetracyclo [4.4.0.1^{2,5}.1^{7,10}] dodec -3-ene, 8,9- di (methoxycarbonyl) tetracyclo [4.4.0.1^{2,5}.1^{7,10}] dodec - 3-ene, 8,9- di (ethoxycarbonyl) tetracyclo [4.4.0.1^{2,5}.1^{7,10}] dodec -3-ene, 8,9- di (n- propoxycarbonyl) tetracyclo [4.4.0.1^{2,5}.1^{7,10}] dodec -3-ene, 8,9- di (iso propoxy carbonyl) tetracyclo [4.4.0.1^{2,5}.1^{7,10}] dodec -3-ene, 8,9- di (n- butoxycarbonyl) tetracyclo [4.4.0.1^{2,5}.1^{7,10}] dodec -3-ene, 8,9- di (t-butoxycarbonyl) tetracyclo [4.4.0.1^{2,5}.1^{7,10}] dodec -3-ene, 8,9- di (cyclohexyloxycarbonyl) tetracyclo [4.4.0.1^{2,5}.1^{7,10}] dodec -3-ene, 8,9- di (phenoxyloxycarbonyl) tetracyclo [4.4.0.1^{2,5}.1^{7,10}] dodec - 3-ene, 8,9- di (tetrahydrofuranyloxycarbonyl) tetracyclo [4.4.0.1^{2,5}.1^{7,10}]-3- dodecen, 8,9- di (tetrahydropyranyloxy carbonyl) tetracyclo [4.4.0.1^{2,5}.1^{7,10}]-3- dodecen, 8,9- tetracyclo [4.4.0.1^{2,5}.1^{7,10}] dodec -3-ene, tetracyclo [4.4.0.1^{2,5}.1^{7,10}] dodec - 3-ene -8-carboxylic acid, 8-methyltetracyclo [4.4.0.1^{2,5}.1^{7,10}] dodec -3-ene -8-carboxylic acid, 8-methyltetracyclo [4.4.0.1^{2,5}.1^{7,10}] dodec -3-ene, 8-ethyl tetracyclo [4.4.0.1^{2,5}.1^{7,10}] dodec -3-ene, 8-methyltetracyclo [4.4.0.1^{2,5}.0^{1,6}] dodec -3-ene, 8-ethylidene tetracyclo [4.4.0.1^{2,5}.1^{7,12}] dodec -3-ene, 8-ethylidene tetracyclo[4.4.0.1^{2,5}.1^{7,10}.0^{1,6}] dodec -3-ene and the like.

It is preferable that the cyclic olefin resin having epoxy group employed is an addition (co)-polymer of norbornene type monomer, generally represented by formula (8).

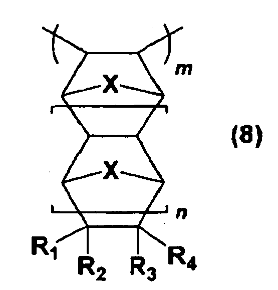

[In formula (8), X is any of O, CH₂ and (CH₂)₂, n is an integer number of 0 to 5, and m is an integer number of 10 to 10,000. R₁ to R₄ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₄ may be the same or different. In formula (8), in R₁ to R₄ of the whole repeated units, at least one or more thereof is functional group having epoxy group.]

Polymers represented by formulae (9), (10) are preferable for the cyclic olefin resin having epoxy group in view of film properties after the cure. Norbornene monomer having aralkyl group is introduced to the polymer as represented by formula (10) to provide an improved solubility to polar solvents such as cyclopentanone or heptanone, which are employed as solvents of negative liquid developer, providing a benefit of improved workability.

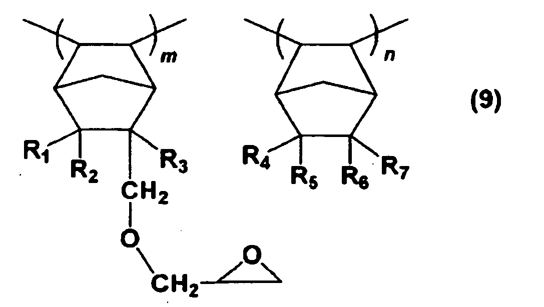

[In formula (9), n and m are integer number of 1 or larger. R₁ to R₇ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₇ may be the same or different.]

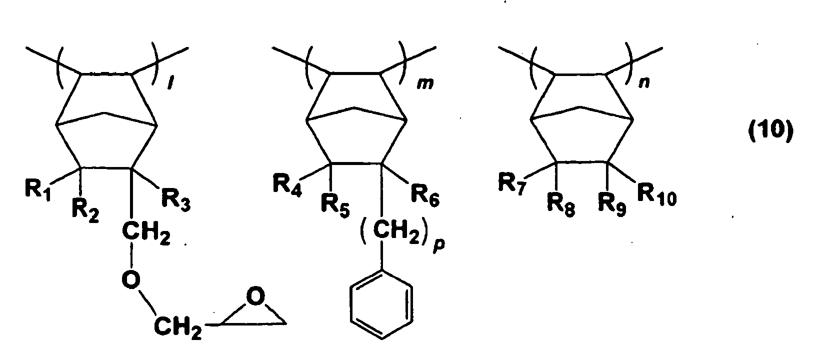

[In formula (10), n and m are integer number of 1 or larger, and p is an integer number of 0 to 5. R₁ to R₁₀ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₁₀ may be the same or different.]

Polymers represented by formula (11) are preferable for the cyclic olefin resin having epoxy group, in view of film properties after the cure. By introducing monomer having decyl group, a film exhibiting lower modulus is obtained, and by introducing monomer having phenylethyl group, a film exhibiting lower moisture absorption, higher chemical resistance and higher polar solvent solubility is obtained.

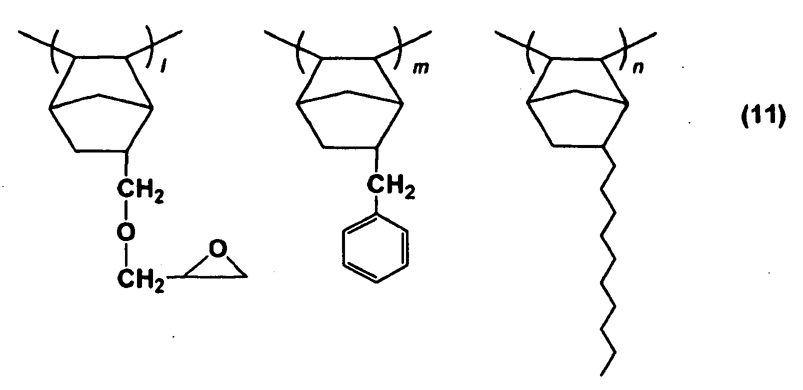

[In formula (11), 1, n and m are integer number of 1 or larger.]

Content of monomer having epoxy group in copolymer may be determined, so that cross-linkages are formed by an exposure to light and a suitable crosslink density for enduring against liquid developer is obtained. Available monomer content having epoxy group in polymer is 5 to 95 mol%, preferably 20 to 80 mol%, and more preferably 30 to 70 mol%. Polymer thus obtained exhibits improved mechanical properties such as lower moisture absorption (< 0.3 %wt.), lower dielectric constant (< 2.6), lower dielectric loss (0.001), glass transition temperature (170 to 400 degree C) or the like.

The crosslinking agent employed for creating cross-linkages in a cyclic olefin resin having epoxy group is a compound generally known as a crosslinker, and for example, a curing agent that exhibits the capability thereof by heating thereof, or a photo reactive material may be employed.

Typical curing agent that is capable of creating cross linkages in a cyclic olefin resin having epoxy group by heating includes aliphatic polyamine, alicycle polyamine, aromatic polyamine, bisazide, acid anhydride, dicarboxylic acid, polyphenol, polyamide and the like. Such curing agent includes, for example: aliphatic polyamines such as hexamethylene diamine, triethylenetetramine, diethylenetriamine, tetraethylenepentamine and the like; alicyclic polyamines such as diaminocyclohexane, 3 (4), 8 (9)-bis (aminomethyl) tricyclo[5,2,1,0^{2,6}] decane, 1,3-(diaminomethyl) cyclohexane, menthene diamine, isophorone diamine, N-aminoethyl piperazine, bis (4-amino-3-methylcyclohexyl) methane, bis (4-aminocyclohexyl) methane and the like; aromatic poly amines such as 4,4'-diaminodiphenyl ether, 4,4'-diaminodiphenyl methane, α,α'- bis (4-aminophenyl)-1,3-diisopropyl benzene, α,α'-bis (4-aminophenyl)-1,4-diisopropyl benzene, 4,4'-diaminodiphenyl sulfone, metaphenylene diamine and the like; bisazides such as 4,4'-bisazide benzal (4-methyl) cyclohexanone, 4,4'-diazide chalcone, 2,6-bis (4'-azide benzal) cyclohexanone, 2,6-bis (4'-azidebenzal) -4-methyl -cyclohexanone, 4,4'-diazide diphenylsulphon, 4,4'-diazide diphenylmethane, 2,2'- diazide stilbene and the like; acid anhydrides such as phthalic anhydride, pyromellitic dianhydride, benzophenone tetracarboxylic acid anhydride, nadic acid anhydride, 1,2-cyclohexanedicarboxylic acid anhydride, maleic anhydride-modified polypropylene, maleic anhydride-modofied cyclic olefin resin and the like; dicarboxylic acids such as fumaric acid, phthalic acid, maleic acid, trimellitic acid, humic acid and the like; polyphenols such as phenolic novolac resin, creosol novolac resin and the like;
polyamides such as nylon-6, nylon-66, nylon-610, nylon-11, nylon-612, nylon-12, nylon-46, methoxymethylated polyamide, poly hexamethylene diamine terephthalamide, poly hexamethylene isophthalic amide and the like. These compounds may be employed alone, a combination of two or more of these compounds may be employed.

A photoacid generator may be employed for the photo reactive material. Any known photoacid generators may be employed. The photoacid generator provides cross linkage of epoxy group and provides an improved adhesiveness with a substrate by being cured thereafter. Preferable photoacid generator includes onium salt, halogenated compounds, sulfates and mixtures thereof. For example typical onium salt includes diazonium salt, ammonium salt, iodonium salt, sulfonium salt, phosphate, arsonium salt, oxonium salt or the like. There is no limitation of counter anion, as long as the compound is capable of creating a counter anion with onium salt as above described. While examples of counter anion include boric acid, arsonium acid, phosphoric acid, antimonic acid, sulfate, carboxylic acid and chlorides thereof, it is not limited thereto. Typical photoacid generator of onium salt includes triphenylsulfonium tetrafluoroborate, triphenyl sulfonium hexafluoro borate, triphenylsulfonium tetrafluoro arsenate, triphenylsulfonium tetrafluorophosphate, triphenylsulfonium tetrafluorosulfate, 4-thiophenoxy diphenylsulfonium tetrafluoroborate, 4-thiophenoxy diphenylsulfonium hexafluoro antimonate, 4- thiophenoxy diphenylsulfonium hexafluoroarsenate, 4- thiophenoxy diphenylsulfonium tetrafluoro phosphate, 4- thio phenoxy diphenylsulfonium trifluorosulfonate, 4-t- butylphenyl diphenylsulfonium tetrafluoroborate, 4-t- butylphenyldiphenyl sulfonium hexafluoroarsenate, 4-t- butylphenyl diphenylsulfonium hexafluoroantimonate, 4-t- butylphenyl diphenylsulfonium hexafluorophosphonate, 4-t- butylphenyl diphenyl sulfonium tri fluorosulfonate, tris (4-methylphenyl) sulfonium tetrafluoroborate, tris (4-methylphenyl) sulfonium hexafluoroarsenate, tris (4-methylphenyl) sulfonium hexafluoro phosphate, tris (4-methylphenyl) sulfonium hexafluorosulfonate, tris (4-methoxyphenyl) sulfonium tetrafluoroborate, tris (4- methylphenyl) sulfonium hexafluoroantimonate, tris (4- methylphenyl) sulfonium hexafluorophosphate, tris (4- methylphenyl) sulfonium tri fluorosulfonate, triphenyliodonium tetrafluoroborate, triphenyl iodonium hexafluoroantimonate, triphenyliodonium hexafluoroarsenate, triphenyliodonium hexafluorophosphonate, triphenyliodonium trifluorosulfonate, 3,3-dinitrodiphenyliodonium tetrafluoroborate, 3,3-dinitro diphenyliodonium hexafluoroantimonate, 3,3-dinitro diphenyliodonium hexafluoroarsenate, 3,3-dinitro diphenyliodonium trifluorosulfonate, 4,4-dinitrodiphenyliodonium tetrafluoroborate, 4,4-dinitrodiphenyliodonium hexafluoro antimonate, 4,4-dinitrodiphenyliodonium hexafluoroarsenate, and 4,4-dinitrodiphenyliodonium trifluorosulfonate, which may be employed alone or in a form of mixture thereof.

Examples of photoacid generators having halogen except fluorine includes 2,4,6-tris (trichloromethyl) triazine, 2-allyl-4,6-bis (trichloromethyl) triazine, α, β, α-tribromomethyl phenyl sulfone, α,α-2,3,5,6- hexachloroxylene, 2,2- bis (3,5-dibromo-4-hydroxyphenyl) -1,1,1,3,3,3- hexafluoroxylene, 1,1,1- tris (3,5-dibromo-4- hydroxyphenyl) ethane and mixtures thereof.

Typical sulfonate-type photoacid generator includes 2-nitrobenzyl tosylate, 2,6- dinitrobenzyl tosylate, 2,4-dinitrobenzyl tosylate, 2- nitrobenzyl methyl sufonate, 2-nitrobenzyl acetate, 9,10- dimethoxy anthracene -2 -sulfonate, 1,2,3- tris (methanesulfonyloxy) benzene, 1,2,3- tris (ethane sulfonyloxy) benzene, 1,2,3- tris (propanesulfonyloxy) benzene or the like, though it is not limited thereto.

Preferable photoacid generator includes 4,4'-di- t-butylphenyliodonium triflate, 4,4',4"-tris (t- butylphenyl) sulfonium triflate, diphenyliodonium tetrakis (pentafluorophenyl) borate, triphenyl sulfonium diphenyliodonium tetrakis (pentafluorophenyl) borate, 4,4'-di-t- butylphenyl iodonium tetrakis (pentafluorophenyl) borate, tris (t-butylphenyl) sulfonium tetrakis (pentafluorophenyl) borate, (4-methylphenyl)-4 -(1-methylethyl) phenyl iodonium tetrakis (pentafluorophenyl) borate and mixtures thereof.
Blending ratio of the photoacid generator in the present invention is typically from 0.1 to 100 parts by weight for 100 parts by weight of the polymer, and more preferably from 0.1 to 10 parts by weight.

The crosslinker of the present invention may be appropriately selected according to an assembly process for a light-receiving device. When the assembly process includes a developing and exposure operations, it is necessary to employ a photo reactive material for the crosslinker. On the other hand, when the assembly process includes no developing or exposure operation, either a curing agent or a photo reactive material may be employed.

A sensitizer may be employed for the cyclic olefin resin composition as required, in order to enhance exposure properties. The sensitizer is capable of providing availability of increased range of wave length that can activate a photoacid generator, and can be added with a range of providing no direct influence on the cross linking reaction of polymer. A photo sensitizer is a compound, which exhibits a maximum absorption constant near that of the employed light source and is capable of effectively providing an absorbed energy to the photoacid generator. Typical sensitizer for the photoacid generator includes polycyclic aromatic compounds such as anthracene, pyrene, parylene and the like. For example, 2-isopropyl-9H- thioxanthene-9 -ene, 4- isopropyl-9H- thioxanthene-9-one, 1- chloro-4- propoxy-thioxanthene, phenothiazine and mixtures thereof may be included. Blending ratio of the photoacid generator in the present invention is typically from 0.1 to 10 parts by weight for 100 parts by weight of the polymer, and more preferably from 0.2 to 5 parts by weight. When the light source is for longer wave such as g- line (436 nm) or i- line (365 nm), sensitizer is effective to activate the photoacid generator.

By adding a smaller amount of an acid scavenger, an improved resolution can be provided. The acid scavenger absorbs an acid diffusing to an unexposed portion during a photochemical reaction. Typical acid scavenger includes pyridine, lutidine, phenothiazine, and secondary and tertiary amines such as tri-n-propyl amine, triethylamine and the like, though it is not limited thereto. Blending ratio of the acid scavenger is typically from 0.01 to 0.05 parts by weight for 100 parts by weight of the polymer.

In a resin composition containing a cyclic olefin resin and a photoacid generator having epoxy group, additives such as a leveling agent, an antioxidant, a fire retardant agent, a plasticizer, a silane coupling agent and the like may be added, as required.

These components are dissolved in a solvent to form a varnish condition for using. Available solvents include non-reactive solvents and reactive solvents, and the non-reactive solvent functions as a carrier for polymers and additives, and are removable in the coating or cure process. The reactive solvent includes reactive group exhibiting a compatibility with a curing agent, which is added in the resin composition. Typical non-reactive solvent includes hydrocarbons and aromatic compounds. Examples thereof include hydrocarbon solvent of alkane or cycloalkane such as pentane, hexane, heptane, cyclohexane, decahydronaphthalene and the like, though it is not limited thereto. Available aromatic solvents include benzene, toluene, xylene, mesitylene and the like. Diethyl ether, tetrahydrofuran, anisole, acetate, ester, lactone, ketone or amide are also useful. Available reactive solvents include cycloether compound such as cyclohexene oxide or α-pinene oxide, aromatic cycloether such as [methylene bis (4,1- phenylene oxy methylene)] bis oxirane and the like, alicyclic vinyl ether compound such as 1,4-cyclohexane dimethanol divinyl ether and the like, and aromatic compound such as bis (4-vinylphenyl) methane and the like, which may be employed alone or in a form of mixture thereof. Preferable compounds are mesitylene and decahydronaphthalene, and these are optimum for applying resins on a substrate of such as silicon, silicon oxide, silicon nitride, silicon oxynitride, of and the like.

Resin solid content in the resin composition employing in the present invention is about 5 to 60 %wt. Further, preferably, it is about 30 to 55 %wt., and more preferably, it is about 35 to 45 %wt. Solution viscosity is 10 to 25,000 cP, and more preferably 100 to 3,000 cP.

A resin composition may be obtained by simply mixing a cyclic norbornene resin having epoxy group and a photoacid generator, and additionally a solvent, a sensitizer, an acid scavenger, a leveling agent, an antioxidant, a fire retardant agent, a plasticizer, a silane coupling agent and the like as required.
Next, a process for preparing a semiconductor device of the present invention will be described. First of all, a norbornene resin composition is coated on a suitable support of, for example, a silicon wafer, a ceramic, an aluminum substrate or the like. Typical application process includes a spin-coating process employing a spinner, a spray-coating process employing a spraying coater, a dipping process, a printing process, a roll coating process or the like. Next, a pre-baking process is conducted at 90 to 140 degree C to dry the coated film, and then, a chemical ray is irradiated to a desired pattern geometry. Available chemical ray includes x-ray, electron beam, ultra-violet ray, visible ray or the like, and those having a wave length of 200 to 700 nm are preferable.

Subsequently to the exposure to chemical ray, a bake process is conducted. Such operation lets rate of reaction of epoxy cross linking increase. Typical baking condition is 50 to 200 degree C, preferably 80 to 150 degree C, and more preferably 90 to 130 degree C.

Next, unirradiated portions are removed by dissolving thereof with a developing solution to obtain a relief pattern. Typical developer includes hydrocarbon-containing solvents including alkane and cycloalkane such as pentane, hexane, heptane, cyclohexane and the like, and aromatic hydrocarbon-containing solvents such as toluene, mesitylene, xylene, mesitylene and the like. Further, terpenes such as limonene, dipentene, pinene, menthane and the like, and ketones such as cyclopentanone, cyclohexanone, 2 -heptanone and the like may be employed, and an organic solvent containing a suitable amount of surfactants added therein may be preferably employed.

Available developing processes include manners utilizing spraying, paddling, dipping, ultrasonic wave and the like. Next, the relief pattern formed by the developing process is rinsed. An alcohol is employed for a rinse solution. Next, a heat treatment process is conducted at 50 to 200 degree C to remove the developer and the rinse solution, and further, cross-linking of epoxy group is completed to obtain a finished pattern that can exhibits better thermal resistance.

Further, the adhesive agent employed in the present invention is preferably composed of silica filler and epoxy resin that is in liquid state at an ambient temperature and a curing agent, and preferably contains 1 to 10 %wt. of silica filler (A) in the component and such silica filler is ultra fine particle silica powder having a mean particle diameter of 2 to 500 nm. Here, the epoxy resin employed in the present invention is limited to liquid at an ambient temperature, and if it is not liquid at an ambient temperature, solvent is additionally needed for kneading with silica filler. The additional solvent causes a generation of voids, which is not preferable as it reduces the adhesive strength and the thermal conductivity of the cured material.

Typical epoxy resins include, for example, bisphenol A, bisphenol F, a compound in liquid state at an ambient temperature such as polyglycidyl ether obtained by a reaction of novolac phenol with epichlorohydrin, vinylcyclohexene dioxide, dicyclopentadiene dioxide, and alicyclic epoxy such as alicyclic diepoxy-azipate, or one of these may be employed or two or more of these may be employed, though it is not limited thereto. Further, a standard epoxy resin such as n-butyl glycidyl ether, versatic acid glycidyl ester, styrene oxide, phenylglycidyl ether, cresyl glycidyl ether, butylphenyl glycidyl ether and the like may also be employed.

For the curing agent employed in the present invention, a simultaneous use of bisphenol F and a latent amine compound such as dicyandiamide, adipic acid hydrazide and the like is preferable, it is preferable to contain bisphenol F with an amount of 2 to 30 %wt. in the adhesive agent. The amount of lower than 2 %wt. provides excessively lower blending quantity, leading to an insufficient adhesive strength, and the amount of larger than 30 %wt. provides excessive amount of phenolic hydroxyl group over epoxy group, leading to remaining unreacted phenolic hydroxyl group in the cured product, and thus these are not preferable.

The silica filler employed in the present invention preferably composed of ultra fine particle silica powder having a mean particle diameter of 2 to 500 nm contained in the adhesive agents at 1 to 10 %wt. The amount of the whole silica filler in the adhesive agent of larger than 1 %wt. eliminates problems in the application such as a dripping of a paste, and the amount of lower than 10 %wt. improves the workability, which is otherwise deteriorated by a plugging of a mask for screen printing or the like. Further, additives such as a cure accelerator, a flexibility-applying agent, a pigment, a dye, an antifoaming agent and the like may be employed as required in the adhesive agent employed in the present invention. The manufacturing method of the present invention includes, for example, pre-mixing respective components, kneading thereof by employing a triple roller to obtain a paste, and defoaming thereof in a vacuum, and the like.

### EXAMPLES

The present invention and illustratives examples will be more specifically described by showing examples hereinafter.

### «Example 1»

### (Manufacture of a cyclic olefin resin composition)

An exemplary implementation of a copolymer (A-1) of 5-decyl-2- norbornene (hereinafter simply referred to as "decyl norbornene")/ 5- [(2,3- epoxypropoxy) methyl]-2- norbornene] (hereinafter simply referred to as "glycidylmethyl ether norbornene") = 70/30 is presented.
All glass devices were dried for 18 hours at 60 degree C and at 0.1 Torr. Thereafter, the glass devices are transferred to a glove box, and were equipped in the glove box. Ethyl acetate (917 g), cyclohexane (917 g), decyl norbornene (192 g, 0.82 mol) and glycidyl methyl ether norbornene (62 g, 0.35 mol) were added to a reaction flask. The reaction flask was taken out from the glove box, and dried nitrogen gas was introduced therein. Intermediate product was degassed by flowing nitrogen gas through a solution thereof for 30 minutes. In the glove box, 9.36 g (19.5 mmol) of a nickel catalyst, namely bis(toluene) bis(perfluoro) phenyl nickel was dissolved in 15 ml of toluene, and was poured in a 25ml syringe, and then was taken out from the glove box, and was added in the reaction flask. It was stirred at 20 degree C for 5 hours to finish the reaction. In next, a solution of peracetic acid (975 mmol) was added therein, and was stirred for 18 hours. When the stirring was stopped, it was separated into a water layer and a solvent layer. After the water layer was separated, one liter of distilled water was added, and was stirred for 20 minutes. A water layer was separated, and was eliminated. Washing was conducted with one liter of distilled water for three times. Thereafter, polymer was added into methanol, and a sediment was collected by a filtration, and it was sufficiently washed with water, and then was dried in the vacuum. After the drying, polymer of 243 g (yield 96 %) was obtained. Molecular weight of the obtained polymer by GPC was: Mw =115,366, Mn =47,000, and Mw/Mn =2.45. Polymer component by H-NMR was: 70 mol% of decyl norbornene, and 30 mol% of epoxy norbornene.

228g of the resin synthesized as above-described was dissolved in 342 g of decahydronaphthalene, and then 4-methylphenyl-4 - (1- methylethyl) phenyl iodonium tetrakis (pentafluorophenyl) borate) (0.2757 g, 2.71 × 10⁻⁴ mol), 1- chloro-4- propoxy -9H- thioxanthone (0.826 g, 2.71 × 10⁻⁴ mol), phenothiazine (0.054 g, 2. 71 × 10⁻⁴ mol), and 3,5-di(t-butyl)-4-hydroxy hydrocinnamate (0.1378 g, 2.60 × 10⁻⁴ mol) were added thereto and dissolved, and then, it was filtered with a 0.2 µm filter made of a fluorine resin to obtain a cyclic olefin resin composition.

### (Manufacture of an adhesive agent)

Ultra fine silica powder having mean particle diameter of about 12 nm (3.0g) and diglycidyl ether obtained by a reaction of bisphenol F and epichlorohydrin (weight per epoxy equivalent: 180, liquid at an ambient temperature) (91.0 g), bisphenol F (5.0 g) and dicyandiamide (1.0 g) were combined, and were kneaded with a triple roller to obtain an insulating resin paste. Such insulating resin paste was defoamed in a vacuum chamber at 2 mmHg for 30 minutes to obtain an adhesive agent.

### (Manufacture of a light-receiving device)

On a semiconductor substrate including the light receiving element having microlenses disposed corresponding to each of the light receiving regions formed thereon and surface electrodes formed in regions except the regions having microlenses, the above-described cyclic olefin resin composition was applied by employing a spin coater, and then was dried with a hot plate at 110 degree C for 5 minutes to obtain a coating film having a film thickness of about 40 µm. An exposure was conducted for portions for forming dams over such coating film through a reticle with a broadband stepper exposure machine (commercially available from ULTRATEC Co., Ltd.) at 1,500 mJ/cm². Thereafter, it was heated with a hot plate at 90 degree C for 4 minutes, for accelerating a cross linking reaction of the exposed portion.

Next, it was dipped in limonene for 30 seconds to dissolve and remove the unexposed portion, and then, a rinse with isopropanol was conducted for 20 seconds. As a result, dams were formed in locations remote from the light receiving elements so as to surround the light receiving elements, and it was confirmed that no residue was found on the microlens. Further, absolutely no pattern delamination was observed in the remained pattern, and found to have an improved adhesiveness in the developing process. Thereafter, a curing was conducted at 160 degree C for 60 minutes to complete the cross linking reaction. The moisture absorption of such cured film was 0.2 %.
Next, the above-described adhesive agent was applied on the formed dams via a screen printing process, and then, the glass substrate is disposed on the dams, a curing was conducted at 100 degree C for 60 minutes to adhere the glass substrate with the dams.
Next, interconnects were formed by employing a method for forming an electric lead that is employed in a shell case-type CSP, and were diced into individual light receiving elements to obtain the light-receiving device. It was confirmed that the obtained light-receiving device exhibited no obstacle in operating as the light-receiving device.

### «Example 2»

Similar process as example 1 except that decyl norbornene (129 g, 0.55 mol), glycidyl methyl ether norbornene (177 g, 0.30 mol) and phenethyl norbornene (29.7 g, 0.15 mol) were employed, in place of employing decyl norbornene (192 g, 0.82 mol) and glycidyl methyl ether norbornene (62 g, 0.35 mol) of example 1, was conducted to obtain a terpolymer (A-2) of decyl norbornene/glycidyl methyl ether norbornene/phenethyl norbornene = 55/30/15. A polymerization and a reprecipitation were conducted to collect a polymer of an amount after drying of 309 g (yield 92 %). Molecular weights of the obtained polymer by GPC were Mw = 68,000, Mn = 30,000 and Mw/Mn = 2.3. Polymer component by H-NMR was: 54 mol% of decyl norbornene, 31 mol% of epoxy norbornene and 15 mol% of phenethyl norbornene.
Operations similar as in example 1 were conducted to obtain the light-receiving device. It was confirmed that the obtained light-receiving device exhibited no obstacle in operating as the light-receiving device.

### «Example 3»

The synthesis and the blending processes same as in the former example were conducted to obtain a cyclic olefin resin composition.

### (Manufacture of a light-receiving device)

On a semiconductor substrate including the light receiving element having microlenses disposed corresponding to each of the light receiving regions formed thereon and surface electrodes formed in regions except the regions having microlenses, the above-described cyclic olefin resin composition was coated by employing a spin coater, and then was dried with a hot plate at 110 degree C for 5 minutes to obtain a coating film having a film thickness of about 40 µm. An exposure was conducted for portions for forming dams over such coating film through a reticle with a broadband stepper exposure machine (commercially available from ULTRATEC Co., Ltd.) at 1,500 mJ/cm². Thereafter, it was heated with a hot plate at 90 degree C for 4 minutes, for accelerating a cross linking reaction of the exposed portion.

Next, it was dipped in limonene for 30 seconds to dissolve and remove the unexposed portion, and then, a rinse with isopropanol was conducted for 20 seconds. As a result, dams were formed in locations remote from the light receiving elements so as to surround the light receiving elements, and it was confirmed that no residue was found on the microlenses. Further, absolutely no pattern delamination was observed in the remained pattern, and found to have an improved adhesiveness in the developing process. Next, a glass substrate is disposed on the formed dams, and a curing was conducted at 160 degree C for 30 minutes while pressuring at 80 kPa to have the glass substrate adhere with the semiconductor substrate. The moisture absorption of such cured film was 0.2 %. Next, interconnects were formed by employing a method for forming an electric lead that is employed in a shell case-type CSP, and were diced into individual light receiving elements to obtain the light-receiving device. It was confirmed that the obtained light-receiving device exhibited no obstacle in operating as the light-receiving device.

### «Example 4»

The synthesis and the blending processes same as in the former example were conducted to obtain a cyclic olefin resin composition.

### (Manufacture of a light-receiving device)

On a semiconductor substrate including the light receiving element having microlenses disposed corresponding to each of the photo light receiving regions formed thereon and surface electrodes formed in regions except the regions having microlenses, the above-described cyclic olefin resin composition was coated by employing a spin coater, and then was dried with a hot plate at 110 degree C for 5 minutes to obtain a coating film having a film thickness of about 10 µm.

Next, a glass substrate is disposed on the coating film, and a curing was conducted at 160 degree C for 30 minutes while pressuring at 80 kPa to have the glass substrate adhere with the semiconductor substrate. The moisture absorption of such cured film was 0.2 %. Next, interconnects were formed by employing a method for forming an electric lead that is employed in a shell case-type CSP, and were diced into individual light receiving elements to obtain the light-receiving device. It was confirmed that the obtained light-receiving device exhibited no obstacle in operating as the light-receiving device.

While the embodiments of above-described the present invention has been described, the present invention is not limited as described above, and various configurations are also included. For example, the present invention includes the following configurations.

### [1]

A light-receiving device that is, composed of: a semiconductor substrate including at least one light receiving element; a dam surrounding the light receiving element provided on the semiconductor substrate; an adhesive agent layer provided on the dam; and a transparent cover provided on the adhesive agent layer, wherein the dam includes a norbornene resin having epoxy group and a photoacid generator.

### [2]

The light-receiving device as set forth in [1], wherein the norbornene resin is a polynorbornene resin.

### [3]

The light-receiving device as set forth in [1] or [2], wherein the norbornene resin which has epoxy group has repeated unit presented by formula (1).

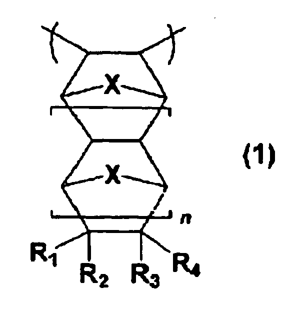

[In formula (1), X is any of O, CH₂ and (CH₂)₂, n is an integer number of 0 to 5. R₁ to R₄ may be respectively any of functional groups selected from hydrogen, alkyl group, alkenyl group, alkynyl group, allyl group, aryl group, aralkyl group, functional group having ester group, functional group having ketone group, monovalent functional group having ether group and monovalent functional group having epoxy group. R₁ to R₄ may be different in repeated monomers, while at least one or more thereof is a functional group having epoxy group among R₁ to R₄ contained in the whole repeated units.]

### [4]

The light-receiving device as set forth in [1] to [3], wherein the norbornene resin having epoxy group includes repeated units presented by formulae (2) and formula (3).

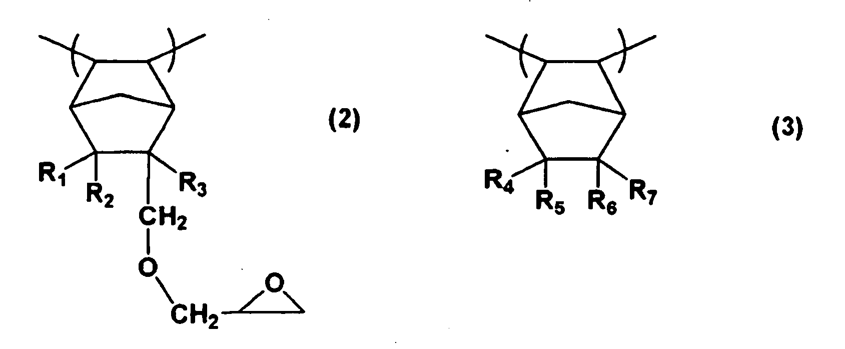

[In formulae (2) and (3), R₁ to R₇ may be respectively any of functional groups selected from hydrogen, alkyl group, alkenyl group, alkynyl group, allyl group, aryl group, aralkyl group, functional group having ester group, functional group having ketone group and monovalent functional group having ether group. R₁ to R₇ may be different in repeated monomers.]

### [5]

The light-receiving device as set forth in [1] to [4], wherein the norbornene resin having epoxy group includes repeated units presented by formulae (4), (5) and (6).

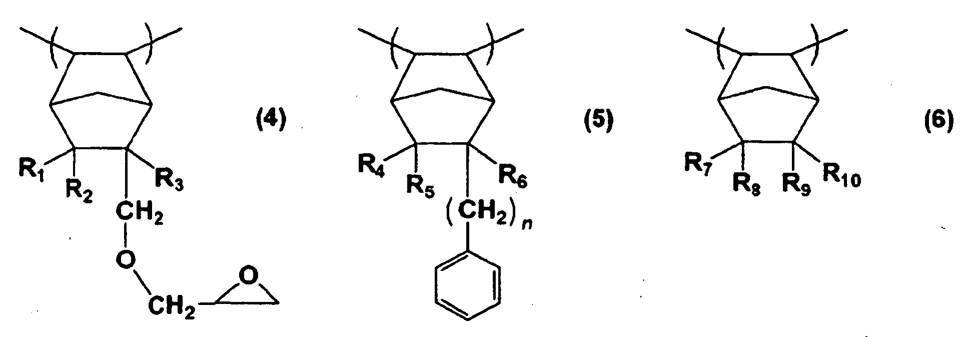

[In formulae (4), (5) and (6), n is an integer number of 0 to 5. R₁ to R₁₀ may be respectively any of functional group selected from hydrogen, alkyl group, alkenyl group, alkynyl group, allyl group, aryl group, aralkyl group, functional group having ester group, functional group having ketone group and monovalent functional group having ether group. R₁ to R₁₀ may be different in repeated monomers.]

### [6]

The light-receiving device as set forth in [1] to [5], wherein the semiconductor substrate described in [1] is silicon, and the light receiving element includes the CMOS image sensor apparatus having microlenses disposed therein.

### [7]

The light-receiving device as set forth in [1] to [6], wherein a height of the dam is higher than the height of a microlens.

### [8]

The light-receiving device as set forth in [1] to [7], wherein the adhesive agent constituting the aforementioned adhesive agent layer is composed of silica filler (A), an epoxy resin that is liquid at an ambient temperature (B) and curing agent (C).

### [9]

The light-receiving device as set forth in [8], wherein 1 to 10 %wt. of silica filler (A) is included in the aforementioned adhesive agent.

### [10]

The light-receiving device as set forth in [8] or [9], wherein mean particle diameter of the silica filler in the aforementioned adhesive agent (A) is 2 to 500 nm.

## Claims

1. A light-receiving device, comprising:
a substrate (1);
a light receiving element (2) provided on a surface of said substrate;
a transparent cover (6) provided above said surface of said substrate; and
a sealing member (5) for providing a seal for said light receiving element from an exterior, said sealing member being at least provided in a circumference of said light receiving element between said substrate and said transparent cover,
**characterised in that** said sealing member contains a norbornene resin.

2. The light-receiving device as set forth in claim 1, wherein said sealing member is provided to surround said light receiving element in a position remote from said light receiving element.

3. The light-receiving device as set forth in claim 1, wherein said sealing member is provided to fill a gap between said substrate and said transparent cover.

4. The light-receiving device as set forth in claim 1, wherein said sealing member is a bridged compound of said norbornene resin having epoxy group.

5. The light-receiving device as set forth in claim 4, wherein said norbornene resin having epoxy group has repeated unit presented by formula (1): 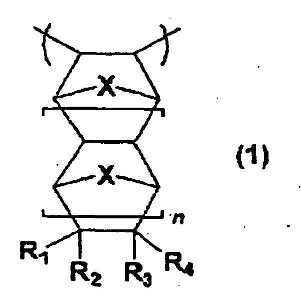 [In formula (1), X is any of O, CH₂ and (CH₂)₂, and n is an integer number of 0 to 5. R₁ to R₄ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₄ may be the same or different. In R₁ to R₄ of the whole repeated units in formula (1), at least one or more thereof is functional group having epoxy group.]

6. The light-receiving device as set forth in claim 4, wherein said norbornene resin having epoxy group has repeated units presented by formula (2) and formula (3), respectively. 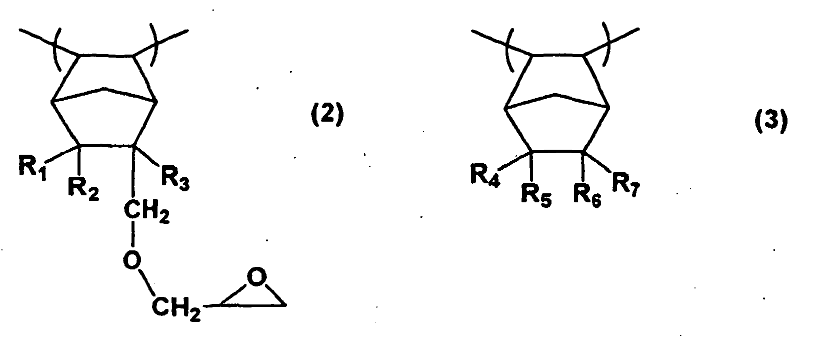 [In formulae (2) and (3), R₁ to R₇ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₇ may be the same or different.]

7. The light-receiving device as set forth in claim 4, wherein said norbornene resin having epoxy group has repeated unit presented by formulae (4), (5) and (6): 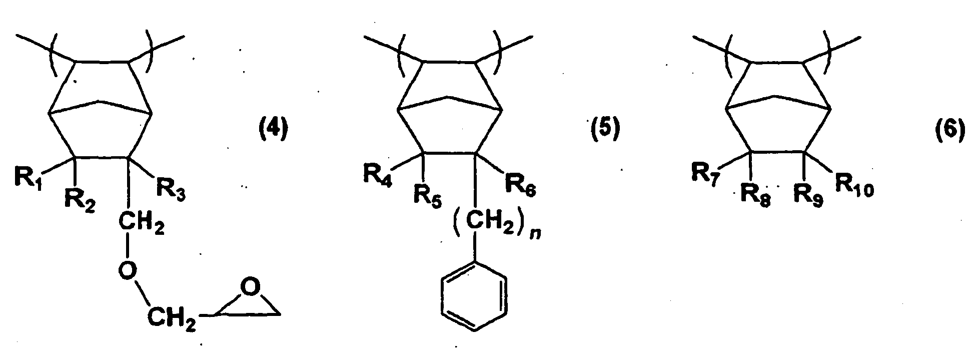 [In formulae (4), (5) and (6), n is an integer number of 0 to 5. R₁ to R₁₀ are respectively any of functional group selected from hydrogen, alkyl group, alkenyl group, alkynyl group, allyl group, aryl group, aralkyl group, monovalent functional group having ester group, monovalent functional group having ketone group, monovalent functional group having ether group and monovalent functional group having epoxy group. R₁ to R₁₀ may be the same or different.]

8. The light-receiving device as set forth in claim 1, wherein a thickness of said sealing member is thicker than a protrusion height of said light receiving element from the substrate.

9. The light-receiving device as set forth in claim 1, wherein said sealing member and said transparent cover are joined through an adhesive agent layer (7).

10. The light-receiving device as set forth in claim 9, wherein said adhesive agent layer is formed by curing the adhesive agent composed of silica filler and epoxy resin that is in liquid state at an ambient temperature and curing agent.

11. The light-receiving device as set forth in claim 10, wherein said adhesive agent includes 1 to 10 %wt. of said silica filler.

12. The light-receiving device as set forth in claim 10, wherein mean particle diameter of said silica filler is 2 to 500 nm.

## Patentansprüche

1. Lichtempfangsvorrichtung, umfassend:
ein Substrat (1),
ein Lichtempfangselement (2), das auf einer Oberfläche des Substrats bereitgestellt wird,
eine transparente Abdeckung (6), die über der Oberfläche des Substrats bereitgestellt wird, und
ein Abdichtungselement (5), um eine Abdichtung für das Lichtempfangselement gegenüber einer Außenseite bereitzustellen, wobei das Abdichtungselement zumindest in einem Umkreis des Lichtempfangselements zwischen dem Substrat und der transparenten Abdeckung bereitgestellt wird,
**dadurch gekennzeichnet, dass** das Abdichtungselement ein Norbornenharz enthält.

2. Lichtempfangsvorrichtung wie in Anspruch 1 dargelegt, wobei das Abdichtungselement bereitgestellt wird, um das Lichtempfangselement in einer Position abseits des Lichtempfangselements zu umgeben.

3. Lichtempfangsvorrichtung wie in Anspruch 1 dargelegt, wobei das Abdichtungselement bereitgestellt wird, um eine Lücke zwischen dem Substrat und der transparenten Abdeckung zu füllen.

4. Lichtempfangsvorrichtung wie in Anspruch 1 dargelegt, wobei das Abdichtungselement eine verbrückte Verbindung des Norbornenharzes mit Epoxygruppe ist.

5. Lichtempfangsvorrichtung wie in Anspruch 4 dargelegt, wobei das Norbornenharz mit Epoxygruppe eine Wiederholungseinheit der Formel (1) aufweist: 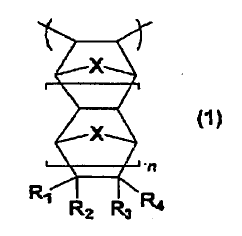 [In Formel (1) ist X ein jegliches von O-Atom, CH₂- und (CH₂)₂-Gruppe, und n ist eine ganze Zahl von 0 bis 5. R₁ bis R₄ sind jeweils eine jegliche funktionelle Gruppe, ausgewählt aus Wasserstoffatom, Alkylgruppe, Alkenylgruppe, Alkinylgruppe, Allylgruppe, Arylgruppe, Aralkylgruppe, monovalenter funktioneller Gruppe mit Estergruppe, monovalenter funktioneller Gruppe mit Ketongruppe, monovalenter funktioneller Gruppe mit Ethergruppe und monovalenter funktioneller Gruppe mit Epoxygruppe. R₁ bis R₄ können gleich oder unterschiedlich sein. Mindestens eine oder mehrere der Gruppen R₁ bis R₄ der gesamten Wiederholdungseinheiten in Formel (1) sind eine funktionelle Gruppe mit Epoxygruppe.]

6. Lichtempfangsvorrichtung wie in Anspruch 4 dargelegt, wobei das Norbornenharz mit Epoxygruppe Wiederholungseinheiten der Formel (2) bzw. der Formel (3) aufweist: 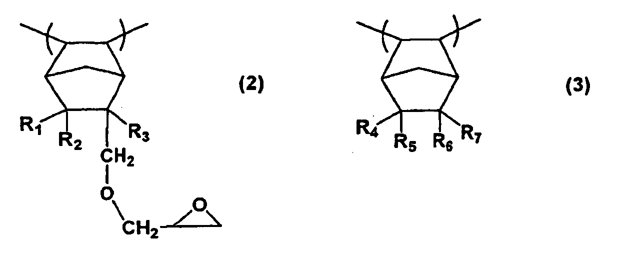 [In den Formeln (2) und (3) sind R₁ bis R₇ jeweils eine jegliche funktionelle Gruppe, ausgewählt aus Wasserstoffatom, Alkylgruppe, Alkenylgruppe, Alkinylgruppe, Allylgruppe, Arylgruppe, Aralkylgruppe, monovalenter funktioneller Gruppe mit Estergruppe, monovalenter funktioneller Gruppe mit Ketongruppe, monovalenter funktioneller Gruppe mit Ethergruppe und monovalenter funktioneller Gruppe mit Epoxygruppe. R₁ bis R₇ können gleich oder unterschiedlich sein.]

7. Lichtempfangsvorrichtung wie in Anspruch 4 dargelegt, wobei das Norbornenharz mit Epoxygruppe eine Wiederholungseinheit der Formeln (4), (5) und (6) aufweist: 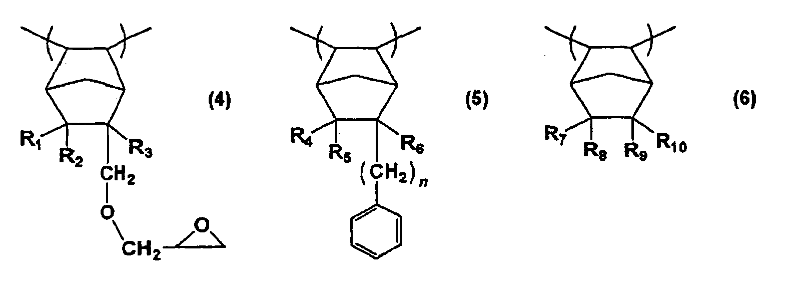 [In den Formeln (4), (5) und (6) ist n eine ganze Zahl von 0 bis 5. R₁ bis R₁₀ sind jeweils eine jegliche funktionelle Gruppe, ausgewählt aus Wasserstoffatom, Alkylgruppe, Alkenylgruppe, Alkinylgruppe, Allylgruppe, Arylgruppe, Aralkylgruppe, monovalenter funktioneller Gruppe mit Estergruppe, monovalenter funktioneller Gruppe mit Ketongruppe, monovalenter funktioneller Gruppe mit Ethergruppe und monovalenter funktioneller Gruppe mit Epoxygruppe. R₁ bis R₁₀ können gleich oder unterschiedlich sein.]

8. Lichtempfangsvorrichtung wie in Anspruch 1 dargelegt, wobei eine Dicke des Abdichtungselements dicker als eine Vorsprungshöhe des Lichtempfangselements von dem Substrat ist.

9. Lichtempfangsvorrichtung wie in Anspruch 1 dargelegt, wobei das Abdichtungselement und die transparente Abdeckung über eine Haftvermittlerschicht (7) verbunden sind.

10. Lichtempfangsvorrichtung wie in Anspruch 9 dargelegt, wobei die Haftvermittlerschicht durch Aushärtung des Haftvermittlers ausgebildet wird, welcher aus einem Silicafüllmaterial und einem Epoxyharz, das bei Umgebungstemperatur in flüssiger Form vorliegt, und einem Aushärtemittel zusammengesetzt ist.

11. Lichtempfangsvorrichtung wie in Anspruch 10 dargelegt, wobei der Haftvermittler 1 bis 10 Gew.-% des Silicafüllmaterials beinhaltet.

12. Lichtempfangsvorrichtung wie in Anspruch 10 dargelegt, wobei der mittlere Partikeldurchmesser des Silicafüllmaterials 2 bis 500 nm beträgt.

## Revendications

1. Dispositif récepteur de lumière, comprenant:
un substrat (1);
un élément récepteur de lumière (2), procuré sur une surface du dit substrat;
une couverture transparente (6) procurée au-dessus de ladite surface du dit substrat; et
un organe de scellement (5) pour procurer un joint pour ledit élément récepteur de lumière à partir d'un extérieur, ledit organe de scellement étant au moins procuré dans une circonférence du dit élément récepteur de lumière entre ledit substrat et ladite ouverture transparente,
**caractérisé en ce que** ledit organe de scellement contient une résine de norbornène.

2. Dispositif récepteur de lumière selon la revendication 1, dans lequel ledit organe de scellement est procuré pour entourer ledit élément récepteur de lumière dans une position éloignée du dit élément récepteur de lumière.

3. Dispositif récepteur de lumière selon la revendication 1, dans lequel ledit organe de scellement est procuré pour combler un intervalle entre ledit substrat et ladite couverture transparente.

4. Dispositif récepteur de lumière selon la revendication 1, dans lequel ledit organe de scellement est un composé ponté de ladite résine de norbornène ayant un groupe époxy.

5. Dispositif récepteur de lumière selon la revendication 4, dans lequel ladite résine de norbornène ayant un groupe époxy possède une unité répétée représentée par la formule (1): 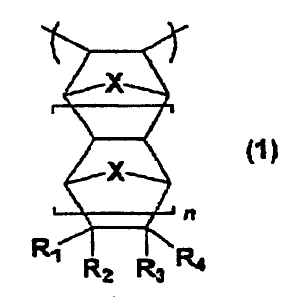 [dans la formule (1), X est l'un quelconque de O, CH₂ et (CH₂)₂, et n est un nombre entier de 0 à 5. R₁ à R₄ sont respectivement l'un quelconque des groupes fonctionnels choisis parmi hydrogène, groupe alkyle, groupe alcényle, groupe acynyle, groupe allyle, groupe aryle, groupe aralkyle, groupe fonctionnel monovalent ayant un groupe ester, groupe fonctionnel monovalant ayant un groupe cétone, groupe fonctionnel monovalant ayant un groupe éther et groupe fonctionnel monovalant ayant un groupe époxy. R₁ à R₄ peuvent être identiques ou différents. Dans R₁ à R₄ de la totalité des unités répétées dans la formule (1), au moins un ou plusieurs d'entre eux est un groupe fonctionnel ayant un groupe époxy.]

6. Dispositif récepteur de lumière selon la revendication 4, dans lequel ladite résine de norbornène ayant un groupe époxy présente des unités répétées représentées par la formule (2) et la formule (3), respectivement: 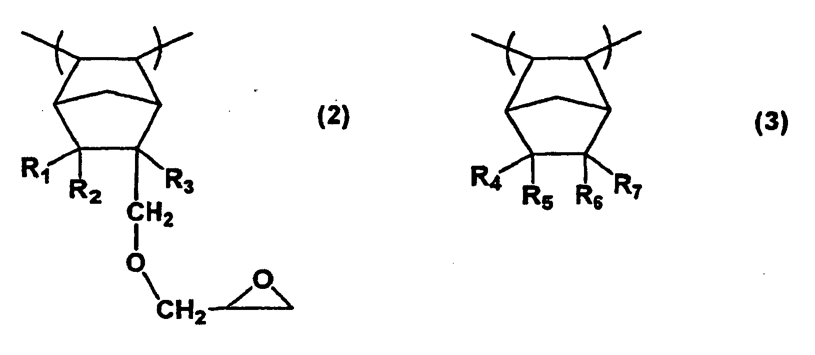 [dans les formules (2) et (3), R₁ à R₇ sont respectivement l'un quelconque des groupes fonctionnels choisis parmi hydrogène, groupe alkyle, groupe alcényle, groupe alcynyle, groupe allyle, groupe aryle, groupe aralkyle, groupe fonctionnel monovalant ayant un groupe ester, groupe fonctionnel monovalant ayant un groupe cétone, groupe fonctionnel monovalant ayant un groupe éther et groupe fonctionnel monovalant ayant un groupe époxy. R₁ à R₇ peuvent être identiques ou différents.]

7. Dispositif récepteur de lumière selon la revendication 4, dans lequel ladite résine de norbornène ayant un groupe époxy possède une unité répétée représentée par les formules (4), (5) et (6): 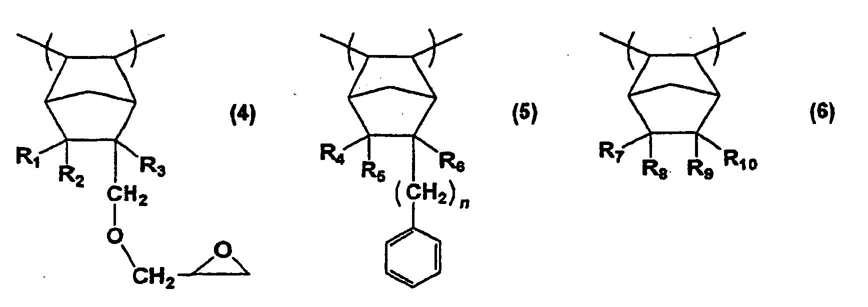 [dans les formules (4), (5) et (6), n est un nombre entier de 0 à 5. R₁ à R₁₀ sont respectivement l'un quelconque des groupes fonctionnels choisis parmi hydrogène, groupe alkyle, groupe alcényle, groupe alcynyle, groupe allyle, groupe aryle, groupe aralkyle, groupe fonctionnel monovalant ayant un groupe ester, groupe fonctionnel monovalant ayant un groupe cétone, groupe fonctionnel monovalant ayant un groupe éther et groupe fonctionnel monovalant ayant un groupe époxy. R₁ à R₁₀ peuvent être identiques ou différents.]

8. Dispositif récepteur de lumière selon la revendication 1, dans lequel l'épaisseur du dit organe de scellement est supérieure à la hauteur de dépassement du dit élément récepteur de lumière à partir du substrat.

9. Dispositif récepteur de lumière selon la revendication 1, dans lequel ledit organe de scellement et ladite couverture transparente sont reliés par une couche d'agent adhésif (7).

10. Dispositif récepteur de lumière selon la revendication 9, dans lequel ladite couche d'agent adhésif est formée par durcissement de l'agent adhésif composé d'une charge de silice et d'une résine époxy qui est à l'état liquide à température ambiante, et d'un agent de durcissement.

11. Dispositif récepteur de lumière selon la revendication 10, dans lequel ledit agent adhésif comprend 1 à 10% en poids de ladite charge de silice.

12. Dispositif récepteur de lumière selon la revendication 10, dans lequel le diamètre moyen des particules de ladite charge de silice est de 5 à 500 nm.
